Europäisches Patentamt

European Patent Office

Office européen des brevets

(19)

(11) Publication number: **0 222 612**
**A2**

# (12) EUROPEAN PATENT APPLICATION

(21) Application number: **86308745.8**

(22) Date of filing: **11.11.86**

(51) Int. Cl.⁴: **G 01 N 30/86**
**G 01 N 30/64**

(30) Priority: **13.11.85 US 797613**

(43) Date of publication of application:
**20.05.87 Bulletin 87/21**

(84) Designated Contracting States:
**AT BE CH DE ES FR GB IT LI NL SE**

(71) Applicant: **ESA, Inc.**
**45 Wiggins Avenue**
**Bedford Massachusetts 01730 (US)**

(72) Inventor: **Matson, Wayne R.**
**One Harvard Road**
**Ayer Massachusetts 01433 (US)**

**Morash, Kenneth R.**
**14 Mount Auburn Street**
**Chelmsford Massachusetts 01824 (US)**

(74) Representative: **Sommerville, John Henry et al**
**SOMMERVILLE & RUSHTON 11 Holywell Hill**
**St. Albans Hertfordshire, AL1 1EZ (GB)**

(54) Simultaneous filtering and background correction of chromatographic data.

(57) Method and apparatus for improving the data displayed and analyzed in the use of liquid chromatographs and the like. Two digital filters are selected, one with $f_p$ and $f_s$ points below the f of the date of interest and one with $f_p$ and $f_s$ points above the f of the signal of interest. These filters are operated simultaneously on the input data form a liquid chromatographic detector or the like which is of relatively low frequency. The first is set such that real input data form chromatographic peaks is rejected and the extremely low frequency drift and curvature in the base line alone is displayed. The second is set such that real input data is accepted and noise from higher frequency sources is rejected. Point-for-point subtraction of the outputs from the simultaneously operating filters then gives a single for the real chromatographic data, corrected for baseline drift and noise.

PRIOR ART

FIG. 1

EP 0 222 612 A2

## Description

SIMULTANEOUS FILTERING AND BACKGROUND CORRECTION OF CHROMATOGRAPHIC DATA

Background of the Invention

Electrochemical testing systems have become increasingly important in the identification of extremely small concentrations of various electrochemically active species in dilute solution, e.g., in the detection and determination of trace impurities in water, detection and determination of trace compounds in biological samples or the like such as neurotransmitters or the like, in biological samples. The invention is particularly useful when electrochemical sensors are used in combination with chromatography and will be described in connection with such utility although other uses are contemplated. Several such systems are described in my earlier patents 4,404,065, 4,497,199, and 4,511,659, the disclosures of which are incorporated herein by reference.

In devices such as liquid chromatographs and the like, the characteristics of a sample are displayed for visual analysis or analyzed by electronic instrumentation from a stream of data produced over a run having an extended time period. Typically, what is analyzed is the height of peaks above a baseline along the time line of the run. Peaks at particular points indicate high concentrations of the component being detected at that point during the duration of the run. Typical raw response data is plotted against time. In order to analyze the data, the height above a baseline must be determined. As will be seen in greater clarity from the discussion hereinafter, the baseline generally is not linear or parallel to the time axis.

Additionally, what may appear as a peak, may in fact turn out to be the result of a high frequency noise spike.

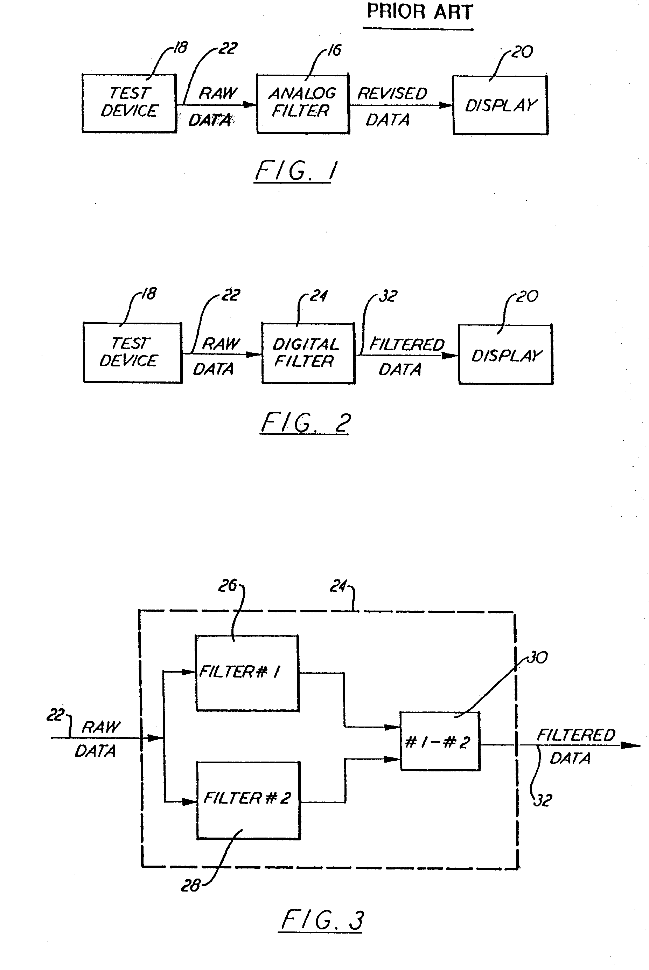

As shown in Figure 1, it is known in the prior art to place a filtering device 16 between the test device 18 and the display 20. As used herein and in the detailed discussion of the present invention that follows, the test device 18 can be any of a number of analytical devices as characterized by liquid or gas chromatographs which produce a stream of data over a time period of analysis during which a spectrum of components are sensed or produce a characteristic output at discrete points in the time domain. The data also can be the output from multisensor coulometric electrochemical detectors. Such devices are well known to those skilled in the art and will not be discussed in any detail herein in the interest of brevity and simplicity. Likewise, references to a "display" should be understood to include electronic or digital data analysis in manners also well known to those skilled in the art. The display 20 is used for purposes of the description herein as it produces a visual display of the problems involved and their manner of solution by the present invention.

The filtering device 16 has two purposes -- to shift the data in an approximation of a straight line baseline and to eliminate noisespikes so that peaks are truly peaks. To this end, many approaches have been attempted. Most providing any reasonable approach to success have been overly complex. Wherefore, it is the object of the present invention to overcome the aforesaid disadvantages of the prior art and to provide a method and apparatus for filtering raw data from a chromatograph or the like which is simple and effective.

SUMMARY

The foregoing object has been achieved in one aspect of the present invention by the method for correcting raw data from a chromatographic detector or the like for baseline drift and noise to provide improved data for analysis comprising the steps of, passing the raw data through a first digital filter on a point by point basis where the first digital filter is adapted to reject real input data from chromatographic peaks and the like and pass any extremely low frequency drift and any curvature in the baseline alone to output a first revised data stream; simultaneously passing the raw data through a second digital filter on a point-by-point basis where the second digital filter is adapted to pass real input data and reject noise from such higher frequency sources as pump fluctuations, pressure spikes and voltage ripple to output a second revised data stream; and, subtracting the second revised data stream from the first revised data stream on a corresponding point-by-point basis to form a corrected data stream to be used for analysis.

In the preferred embodiment, the first digital filter has $f_p$ and $f_s$ points below the f of the data of interest; the second digital filter has $f_p$ and $f_s$ points above the f of the data of interest; and the method additionally comprises the step of, decreasing the first and second digital filters in their respective $f_p$ and $f_s$ points during an analysis run of the detector during which the filters are revising data to maintain a ratio between the $f_p$ and $f_s$ points such that optimization of data over the entire run is achieved.

The apparatus of the preferred embodiment to accomplish the foregoing method comprises a first digital filter means for passing the raw data through on a point-by-point basis to reject real input data from chromatographic peaks and the like and pass the extremely low frequency drift and curvature in the baseline alone and output a first revised data stream; a second digital filter means for passing the raw data through on a point-by-point basis to pass real input data and reject noise from such higher frequency sources as pump fluctuations, pressure spikes and voltage ripple and output a second revised data stream; and, means for subtracting the second revised data stream from the first revised data stream on a corresponding point by point basis to form a corrected data stream to be used for analysis.

In the apparatus of the preferred embodiment, the first digital filter means has $f_p$ and $f_s$ points below the f of the data of interest; the second digital filter means has $f_p$ and $f_s$ points above the f of the data of interest; and the first and second digital filter means are adapted to decrease in their respective $f_p$ and $f_s$ points during an

analysis run of the detector during which the filter means are revising data and to maintain a ratio between their respective $f_p$ and $f_s$ points such that optimization of the data over the entire run is achieved.

## Description of the Drawings

For a fuller understanding of the nature and objects of the present invention, reference should be had to the following detailed description taken in combination with the accompanying drawings: Wherein

Figure 1 is a block diagram of a prior art analysis system including filtering of the raw analog data;

Figure 2 is a block diagram of an analysis system according to the present invention;

Figure 3 is a more detailed block diagram of the digital filter of the present invention;

Figure 4 is a graph of response vs. time for unfiltered data from a liquid chromatograph or the like;

Figure 5 is a graph of response vs. time for the output of Filter #1 in the present invention;

Figure 6 is a graph of response vs. time for the output of Filter #2 in the present invention; and

Figure 7 is a graph of response vs. time for the results of subtracting the output of Filter #2 from the output of Filter #1 in the present invention.

## Description of the Preferred Embodiment

The present invention and the results it produces are shown in Figures 2-7. As shown in Figure 2, the output 22 from the test device 18 is input to a digital filter 24. While the raw data output at 22 from the test device 18 may be analog in nature, techniques well known to those skilled in the art which form no part of the present invention may be used to digitize the data into a stream of digital data points.

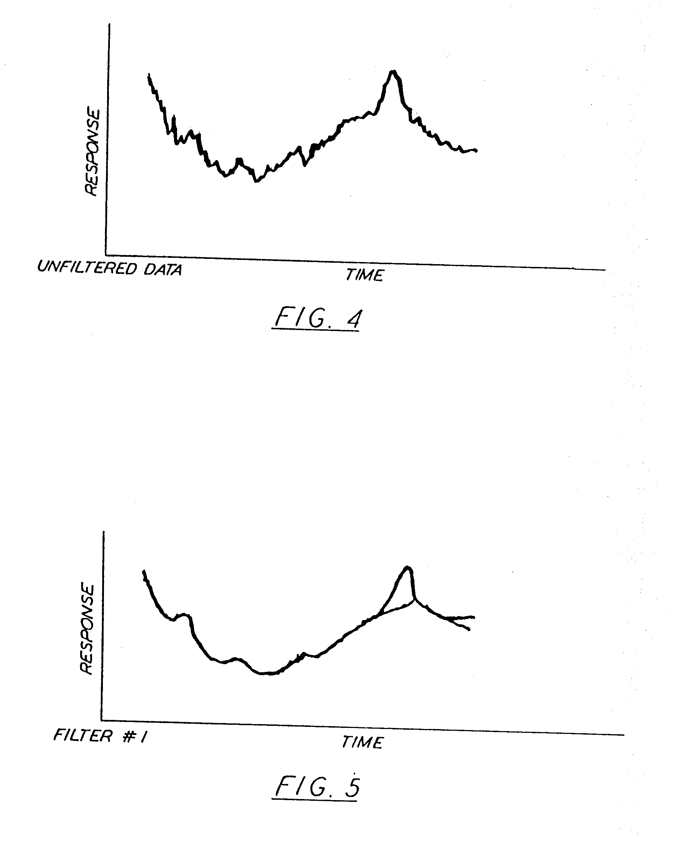

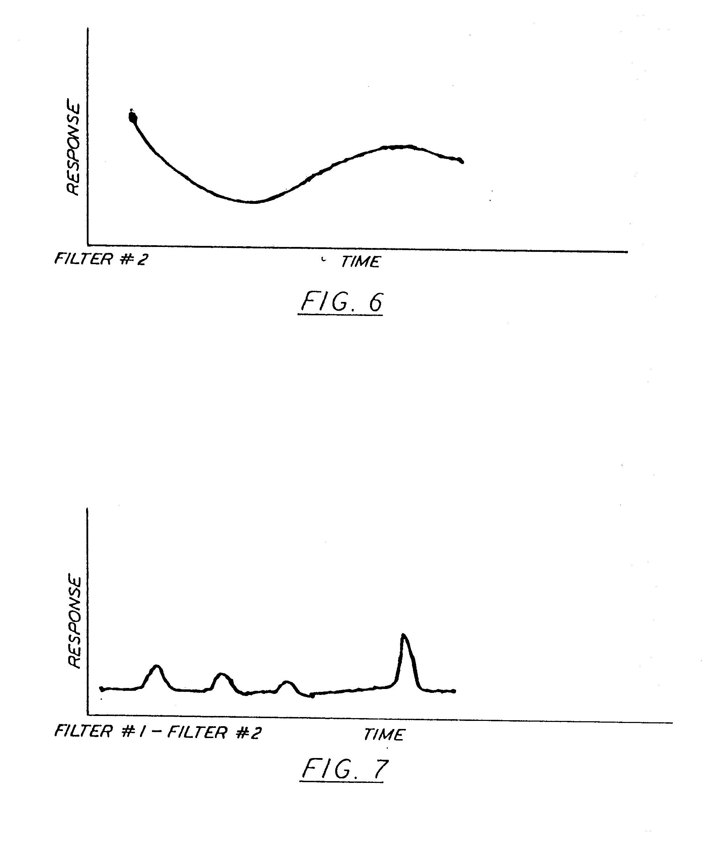

As shown in Figure 3 in more detail, the digital filter 24 comprises two filters 26, 28 which receive the raw data input at 22 simultaneously on a point-by-point basis. For purposes for discussion, filter 26 is referred to as "Filter #1" and filter 28 is referred to as "Filter #2". The performance criteria of the filters 26,28 will be discussed in greater detail shortly. As can be seen, the output from the filters 26,28 (shown in Figure 5 and 6, respectively) are input to a subtraction logic block 30 wherein the respective corresponding data points outputs from the filters 26,28 are subtracted to form a filtered data stream (such as shown in Figure 7) on output line 32, which filtered data is used for the analysis as at display 20.

Two digital filters are selected for filters 26,28, one with $f_p$ and $f_s$ points below the f of the data of interest and one with $f_p$ and $f_s$ points above the f of the signal of interest. The filters 26,28 operate simultaneously on the input data from a liquid chromatographic detector, or the like, which is of relatively low frequency (e.g. 0.1 - 0.01Hz). The first, Filter #2, is set such that real input data from chromatographic peaks is rejected and the extremely low frequency drift and curvature in the baseline alone is displayed as in Figure 6.The second, Filter #1, is set such that real input data is accepted and noise from such higher frequency sources as pump fluctuates, pressure spikes and voltage ripple is rejected as in Figure 5. Point-for-point subtraction at 30 of the output from the simultaneously operating filters 26,28 then gives a signal for the real chromatograhic data at 32, corrected for baseline drive and noise as in Figure 7.

It is the nature of the chromatographic data that the frequency of peaks increases with the time of the run. Thus, it is also desirable and preferred as a refinement to the above method and apparatus to have each filter 26,28 vary (decrease) in its $f_s$ and $f_p$ points during the run and maintain a ratio between the respective $f_s$ and $f_p$ points such that optimization of data over the entire run will be achieved. The manner of accomplishing this in each case is easily implemented by those skilled in the art using well known techniques and without undue experimentation.

The characteristics of the filters 26,28 according to a tested and preferred embodiment will now be discussed in greater detail.

In the most general terms, a digital filter is the transformation of one set of numerical values, $f_m$, into another set, $g_m$. If $f_m$ is a set of sampled or digitized values of an analog signal, then a transformation can be found such that $g_m$ is a set of sampled values of the filtered analog signal discribed by $f_m$. "Filtered" in this case means passing certain frequencies in the signal and rejecting others.

If a linear nonrecursive algorithm is used to express the transformation, then the filter is an FIR (finite impulse response) filter. The general form of this transformation is shown in Equation #1 below:

$$g_m = \sum_{n=-N}^{N} b_n f_{m-n} \qquad (1)$$

The set of values, $b_n$ is called the filter coefficients.

Preferably the digital filters are low pass FIR (finite impulse response). FIR filters were chosen because they have linear phase, i.e., no frequency dispersion. For example, for data sampling rates in the range of from e.g. 1 to 100 Hz, the signals can be filtered with FIR filters with 80 dB/octave roll off and cutoff frequencies ranging from e.g. 5 Hz to 0.01 Hz. The filters to be employed have been designed with the Remez exchange algorithm of Parks and McClellan. (T.W. Parks and J.H. McLellan, "A Program for the Design of Linear Phase Finite Impulse Response Digital Filters", IEEE Trans. on Audio and Electroacoustics, AU-20, No. 3, 195-199, August 1972.)

0 222 612

The Algorithm in Equation #1 for an FIR filter is extremely easy to implement on a digital computer. A low pass FIR filter with 80 dB/octave roll off and a cutoff frequency of 0.01 Hz requires on the order of 30,000 filter coefficients and thus an extremely large amount of computation to implement.

In order to reduce the amount of computation required, the low pass FIR filter (Filter #2) preferably will be implemented using the decimation/interpolation technique of Cochiere and Rabiner. (R.E. Cochiere and L.R. Rabiner, "Optimum FIR Digital Filter Implementation for Decimation, Interpolation, and Narrow-Band Filtering", IEEE Trans. on Acoustics, Speech and Signal Processing, Vol. ASSP-23, No. 5, October 1975.)

This is based on the fact that if a signal is low pass filtered, then its sampling rate can be reduced without losing any information. When low pass filtering in stages and reducing the sampling rate, FIR filters with less roll off can be used. The less sharp the roll off of the filter, the fewer the number of required filter coefficients. After low pass filtering and decimating the sampling rate of the signal, the signal can be returned to its original sampling rate by using the same low pass filters to interpolate the filtered signal. A low pass FIR filter with 80 dB/octave roll off and a cutoff frequency of 0.01 Hz can be implemented by this method with the equivalent of approximately 100 filter coefficients.

The following is presented as an example of the selection parameters employed for the dual filter approach of the present invention.

- To filter a data run with different $f_s$ and $f_p$ filter pairs:

- Initially, the test data is digitally filtered by a (Data General) Model 10SP computer in two separate runs. An auxiliary processor board is used to do dual digital filtering simultaneously with a dual board capability.

- The I/E cutoff frequency for a 0.1 second filter response is set at 3-5 Hz (3 dB point). This built-in response serves as an anti-aliasing filter. The minimum sampling rate for any filter is thus 10 Hz (from the Nyquist frequency and the above anti-aliasing filter).

- The preferred data sampling rates are: 1, 2, 5, 10, 15, 20, 25, 30, 35, 40, 45, 50, 60, 70, 80, 90 and 100 Hz. The real sampling rate, however, never should go below about 10 Hz. The lower data sampling rates will be obtained with decimation low pass filters.

- The preferred filter response times are : 0.1, 0.2, 0.4, 0.8, 1, 2, 4, 8, 15, 20, 30 and 40 seconds, although any sampling rate and any filter response time can be used for chromatographic data.

- Each set of filter coefficients requires approximately 0.5 K bytes of disk storage based on an average of 100 coefficients (total) for a 2 or 3 stage decimation/interpolation filter.

- 98 sets of filter coeffecients are employed to implement the 12 filter responses at the 17 sampling frequencies. All the filter coefficients thus require approximately 49 K bytes of disk space.

The correlation between sampling rate and minimum peak width is shown in Table 1.

## TABLE 1

| Sampling Rate (Hz) | Minimum Peak Width (sec) |
|:---:|:---:|
| 5 | 4 |
| 2 | 10 |
| 1 | 20 |

For a digital filter with 80 db/octave roll off, the relation between cutoff frequency ($f_p$) and filter response (FR) is:

$$f_p = (0.3764)/FR \quad (2)$$

Therefore, $f_p$ for a 0.1 sec filter is approximately 5 Hz and the minumum sampling rate should be 10 Hz.

Table 2 shows the equivalency of a different set of digital filters. Each number in Table 2 represents a decimation/interpolation digital filter, which can be used to select the optimum $f_s$ and $f_p$ ratios of simultaneously operating filters.

4

## TABLE 2

| Filter Response | 0.1 | 0.2 | 0.4 | 0.8 | 1 | 2 | 4 | 8 | 15 | 20 | 30 | 40 |
|---|---|---|---|---|---|---|---|---|---|---|---|---|
| **Sampling Rate** | | | | | | | | | | | | |
| 1 | 84 | 16 | 66 | 68 | 89 | 83 | 67 | 28 | 88 | 2 | 91 | 3 |
| 2 | 16 | 66 | 68 | 73 | 83 | 67 | 28 | 29 | 77 | 3 | 82 | 32 |
| 5 | 91 | 89 | 83 | 67 | 12 | 1 | 2 | 3 | 92 | 5 | 33 | 6 |
| 10 | 89 | 83 | 67 | 28 | 1 | 2 | 3 | 4 | 33 | 6 | 61 | 7 |
| 15 | 85 | 74 | 50 | 51 | 86 | 75 | 54 | 55 | 87 | 61 | 76 | 60 |
| 20 | 83 | 67 | 28 | 29 | 2 | 3 | 32 | 33 | 61 | 7 | 69 | 8 |
| 25 | 78 | 12 | 1 | 2 | 79 | 13 | 5 | 6 | 80 | 81 | 14 | 15 |
| 30 | 74 | 50 | 51 | 52 | 75 | 54 | 55 | 56 | 76 | 60 | 58 | 36 |
| 35 | 69 | 39 | 40 | 41 | 70 | 43 | 44 | 45 | 71 | 72 | 47 | 48 |
| 40 | 67 | 28 | 29 | 30 | 3 | 32 | 33 | 34 | 60 | 8 | 36 | 37 |
| 45 | 62 | 17 | 18 | 19 | 63 | 21 | 22 | 23 | 64 | 65 | 25 | 26 |
| 50 | 12 | 1 | 2 | 3 | 13 | 5 | 6 | 7 | 14 | 15 | 9 | 10 |
| 60 | 50 | 51 | 52 | 53 | 54 | 55 | 56 | 57 | 58 | 36 | 59 | 38 |
| 70 | 39 | 40 | 41 | 42 | 43 | 44 | 45 | 46 | 47 | 48 | 49 | 95 |
| 80 | 28 | 29 | 30 | 31 | 32 | 33 | 34 | 35 | 36 | 37 | 38 | 94 |
| 90 | 17 | 18 | 19 | 20 | 21 | 22 | 23 | 24 | 25 | 26 | 27 | 93 |
| 100 | 1 | 2 | 3 | 4 | 5 | 6 | 7 | 8 | 9 | 10 | 11 | 12 |

Various changes may be made in the above described invention without departing from the spirit and scope thereof. For example, an alternative method for implementing the digital filters is to use decimation filters to reduce all data to a set sampling rate. Another set of filters could then be used to obtain the desired filter response. This requires 16 rate decimation and 12 response filters for a total of 28 (as comprared to 96 above). It should be noted however that this method requires calculating an extra filter for every set of data.

Thus, it can be seen that the present invention has met its stated objective by providing a method and apparatus for quickly and easily filtering raw data from a test device to linearize the baseline and remove noise.

**Claims**

1. The method of correcting raw data from a chromatographic detector or the like for baseline drift and noise to provide improved data for analysis comprising the steps of:

(a) passing the raw data through a first digital filter on a point-by-point basis where the first digital filter is adapted to reject real input data from chromatographic peaks and the like and pass the extremely low frequency drift and curvature in the baseline alone to output a first revised data stream;

(b) simultaneously passing the raw data through a second digital filter on a point-by-point basis where the second digital filter is adapted to pass real input data and reject noise from such higher frequency sources as pump fluctuates, pressure spikes and voltage ripple to output a second revised data stream; and,

(c) subtracting the second revised data stream from the first revised data stream on a corresponding point-by-point basis to form a corrected data stream to be used for analysis.

2. The method of claim 1 wherein:

the first and second digital filters are selected to have different $f_p$ and $f_s$ points.

3. The method of claim 2 wherein:

(a) the first digital filter has $f_p$ and $f_s$ points below the f of the data of interest; and,

(b) the second digital filter has $f_p$ and $f_s$ points above the f of the data of interest.

4. The method of claim 1 wherein:

(a) the first digital filter has $f_p$ and $f_s$ points below the f of the data of interest;

(b) the second digital filter has $f_p$ and $f_s$ points below the f of the data of interest; and additionally comprising the step of,

(c) decreasing the first and second digital filters in their respective $f_p$ and $f_s$ points during an analysis run of the detector during which the filters are revising data to maintain a ratio between the $f_p$ and $f_s$ points such that optimization of data over the entire run is achieved.

5. Apparatus for correcting raw data from a chromatographic detector or the like for baseline drift and noise to provide improved data for analysis comprising:

(a) first digital filter means for passing the raw data through on a point-by-point basis to reject real input data from chromatographic peaks and the like and pass the extremely low frequency drift and curvature in the baseline alone and output a first revised data stream;

(b) a second digital filter means for passing the raw data through on a point-by-point basis to pass real input data and reject noise from such higher frequency sources as pump fluctuates, pressure spikes and voltage ripple and output a second revised data stream; and,

(c) means for subtracting said second revised data stream from said first revised data stream on a corresponding point-by-point basis to form a corrected data stream to be used for analysis.

6. The apparatus of claim 5 wherein:

said first and second digital filter means have different $f_p$ and $f_s$ points.

7. The apparatus of claim 6 wherein:

(a) said first digital filter means has $f_p$ and $f_s$ points below the f of the data of interest; and,

(b) said second digital filter means has $f_p$ and $f_s$ points above the f of the data of interest.

8. The apparatus of claim 5 wherein:

(a) said first digital filter means has $f_p$ and $f_s$ points below the f of the data of interest;

(b) said second digital filter means has $f_p$ and $f_s$ points below the f of the data of interest;

(c) said first and second digital filter means are adapted to decrease in their respective said $f_p$ and $f_s$ points during an analysis run of the detector during which said filter means are revising data an to maintain a ratio between their respective said $f_p$ and $f_s$ points such that optimization of data over the entire run is achieved.

PRIOR ART

TEST DEVICE | RAW DATA → | ANALOG FILTER | REVISED DATA → | DISPLAY

*FIG. 1*

TEST DEVICE | RAW DATA → | DIGITAL FILTER | FILTERED DATA → | DISPLAY

*FIG. 2*

RAW DATA → FILTER # 1 → #1 – #2 → FILTERED DATA

FILTER # 2 →

*FIG. 3*

0222612

UNFILTERED DATA       TIME

*FIG. 4*

FILTER #1       TIME

*FIG. 5*

0222612

FILTER #2         TIME

*FIG. 6*

FILTER #1 — FILTER #2         TIME

*FIG. 7*